# EUROPEAN PATENT APPLICATION

(11) **EP 4 492 939 A1**
(43) Date of publication of application: **15.01.2025**
(21) Application number: 23382714.6
(22) Date of filing: 12.07.2023
(51) Int. Cl.: H10K 30/35, H01L 31/0296, H10K 30/30

(54) **A PHOTODETECTOR DEVICE**

(71) Applicant: Fundació Institut de Ciències Fotòniques, 08860 Castelldefels (ES); Institució Catalana De Recerca I Estudis Avançats (ICREA), 08010 Barcelona (ES)
(72) Inventor: KONSTANTATOS, Gerasimos, 08860 CASTELLDEFELS (ES); WANG, Yongjie, 08860 CASTELLDEFELS (ES)
(74) Representative: Ponti & Partners, S.L.P

(57) **Abstract**

The present invention relates to a photodetector device, comprising:
- a substrate (S);
- a first electrode (E1) defined by the substrate (S) or arranged thereon;
- an electron transporting structure (ETL) arranged over the first electrode (E1);
- a light-active absorbing structure (A) arranged over the electron transporting structure (ETL) and containing a quantum dot population comprising silver chalcogenide quantum dots, made to absorb at least one of infrared light, near infrared light, and short-wavelength infrared light;
- a second electrode (E2) arranged over the light-active absorbing structure (A); and
- a buffer structure (B), arranged between the electron transporting structure (ETL) and the light-active absorbing structure (A), wherein the buffer structure (B) is configured to reduce interface recombination.

## Description

Results incorporated in this standard have received funding from the European Research Council (ERC) under the European Union's Horizon 2020 research and innovation programme (grant agreement No 101002306).

### FIELD OF THE INVENTION

The present invention generally relates to a photodetector device comprising an environmentally friendly light-active absorbing structure with silver chalcogenide quantum dots, and providing a reduced dark current and improved photo-detectivity.

### BACKGROUND OF THE INVENTION

Infrared photodetection is of great interest for a wide range of applications, such as night vision, automobile autopilot and surveillance, etc. [1-5]. Currently, infrared photodetectors mainly rely on materials with epitaxial growth method, making them exceptionally high cost. In the past decade, colloidal quantum dots have emerged as an important low-cost substitutes for infrared photodetectors, thanks to their solution-processibility, size-tuneable spectral sensitivity and compatibility with silicon electronics integration.

Lead chalcogenide, especially lead sulfide PbS, has gained attention for the applications in infrared photodetection and they have achieved figures of merit outperforming conventional photodetectors. Vafaie et al. have reported an efficient ligand-exchange route that was able to tailor the halide passivants and obtained efficient passivation and improved charge transport [6]. They reported a high external quantum efficiency of 80% at 1550nm, a measured detectivity of 8×10¹¹ Jones and 10ns response time. Biondi et al further reported a colloidal-phase reconstruction of PbS quantum dot surfaces, improving the facet alignment in CQD solids [7]. The photodiodes have reached an EQE (External Quantum Efficiency) of 70% at 1550nm and high specific detectivity over 10¹² Jones and 7ns response time. Mercury telluride quantum dots are also implemented into infrared photodiodes [8,9]. Yang et al reported a ligand-engineered approach that produces monodisperse HgTe QDs with sharp excitonic absorption peak [10]. They also demonstrated a high performance photodiode device based on HgTe QDs with detectivity of 3.9×10¹¹ Jones at 1.7 µm.

Although lead chalcogenide and mercury chalcogenide based photodiodes achieved impressive performance, the toxicity of lead and mercury severely limit their applications and commercialization. Non-toxic Indium Arsenide quantum dots have also been introduced into infrared photodetection. Sun et al reported a photodiode based on InAs QDs with EQE of 30%, measured detectivity of 10¹¹ Jones and fast response speed of 2ns [11]. However, their spectral sensitivity limited at <1000nm, hindering their further applications.

Silver telluride quantum dots, as a member of silver chalcogenides, without toxic elements, are very promising for infrared photodetections [12-14].

Ouyang et al reported a Ag₂Te QDs based photodiodes, particularly comprising the features of the preamble of claim 1. However, the device showed poor performance with EQE < 0.5% at NIR region [15].

It is, therefore, necessary to provide an alternative to the state of the art by providing a photodetector device with a higher performance, in terms of dark current, noise, photoresponsivity, detectivity and bandwidth.

### References:

[1] Ackerman, M. M., Tang, X. & Guyot-Sionnest, P. Fast and Sensitive Colloidal Quantum Dot Mid-Wave Infrared Photodetectors. ACS Nano 12, 7264-7271 (2018).
[2] Christodoulou, S. et al. Single-Exciton Gain and Stimulated Emission Across the Infrared Telecom Band from Robust Heavily Doped PbS Colloidal Quantum Dots. Nano Lett. 20, 5909-5915 (2020).
[3] Gao, L. et al. Efficient near-infrared light-emitting diodes based on quantum dots in layered perovskite. Nat. Photonics 14, 227-233 (2020).
[4] Huo, N. et al. Engineering Vacancies in Bi2S3 yielding Sub-Bandgap Photoresponse and Highly Sensitive Short-Wave Infrared Photodetectors. Advanced Optical Materials 7, 1900258 (2019).
[5] Pradhan, S. et al. High-efficiency colloidal quantum dot infrared light-emitting diodes via engineering at the supra-nanocrystalline level. Nature Nanotech 14, 72-79 (2019).
[6] Vafaie, M. et al. Colloidal quantum dot photodetectors with 10-ns response time and 80% quantum efficiency at 1,550 nm. Matter 4, 1042-1053 (2021).
[7] Biondi, M. et al. Facet-Oriented Coupling Enables Fast and Sensitive Colloidal Quantum Dot Photodetectors. Advanced Materials n/a, 2101056.
[8] Keuleyan, S., Lhuillier, E., Brajuskovic, V. & Guyot-Sionnest, P. Mid-infrared HgTe colloidal quantum dot photodetectors. Nature Photon 5, 489-493 (2011).
[9] Gréboval, C. et al. Mercury Chalcogenide Quantum Dots: Material Perspective for Device Integration. Chem. Rev. 121, 3627-3700 (2021).
[10] Yang, J. et al. Ligand-Engineered HgTe Colloidal Quantum Dot Solids for Infrared Photodetectors. Nano Lett. acs.nanolett.2c00950 (2022) doi:10.1021/acs.nanolett.2c00950.
[11] Sun, B. et al. Fast Near-Infrared Photodetection Using III-V Colloidal Quantum Dots. Advanced Materials 34, 2203039 (2022).
[12] Liu, Z.-Y. et al. Breaking through the Size Control Dilemma of Silver Chalcogenide Quantum Dots via Trialkylphosphine-Induced Ripening: Leading to Ag2Te Emitting from 950 to 2100 nm. J. Am. Chem. Soc. jacs.1c06661 (2021) doi:10.1021/jacs.1c06661.
[13] Lee, W.-Y. et al. Room-Temperature High-Detectivity Flexible Near-Infrared Photodetectors with Chalcogenide Silver Telluride Nanoparticles. ACS Omega 7, 10262-10267 (2022).
[14] Kim, G., Choi, D., Eom, S. Y., Song, H. & Jeong, K. S. Extended Short-Wavelength Infrared Photoluminescence and Photocurrent of Nonstoichiometric Silver Telluride Colloidal Nanocrystals. Nano Lett. acs.nanolett.1c02407 (2021) doi:10.1021/acs.nanolett.1c02407.
[15] Ouyang, J. et al. Ag2Te Colloidal Quantum Dots for Near-Infrared-II Photodetectors. ACS Appl. Nano Mater. 4, 13587-13601 (2021).

### SUMMARY OF THE INVENTION

To that end, the present invention relates to a photodetector device, comprising:
- a substrate;
- a first electrode defined by said substrate or arranged thereon;
- an electron transporting structure arranged over said first electrode;
- a light-active absorbing structure arranged over said electron transporting structure and containing a quantum dot population comprising silver chalcogenide quantum dots, made to absorb at least one of infrared light, near infrared light, and short-wavelength infrared light; and
- a second electrode arranged over said light-active absorbing structure.

In contrast to the photodetector devices of the prior art, the photodetector device of the present invention further comprises a buffer structure, arranged between the electron transporting structure and the light-active absorbing structure, wherein said buffer structure is configured to reduce interface recombination.

For an embodiment, the photodetector device further comprises a hole transporting structure, arranged between the light-active absorbing structure and the second electrode.

According to an embodiment, the photodetector device is a top-illuminated photodetector, the second electrode is configured, sized and arranged to allow at least one of impinging infrared light, impinging near infrared light, and impinging short-wavelength infrared light to transmit therethrough and be absorbed by the light-active absorbing structure.

For an embodiment, a readout integrated circuit (ROIC) is built on the substrate.

The top-illuminated photodetector is compatible with the ROIC. For an embodiment, the electron transporting structure was deposited onto the first electrode, followed by the buffer and light-active absorbing structures. The device finishes with a thin metal second electrode (preferably below 50nm) on top, such that light can transmit through and be absorbed by the light-active absorbing structure.

For some embodiments, the chalcogenide ion in the silver chalcogenide quantum dots of the light-active absorbing structure is at least one of sulfide, selenide, telluride, or combinations thereof.

For an embodiment, the silver chalcogenide quantum dots of the light-active absorbing structure are Ag₂Te quantum dots.

According to an embodiment, the silver chalcogenide quantum dots of the light-active absorbing structure are solution deposited.

For an embodiment, the silver chalcogenide quantum dots of the light-active absorbing structure have surface ligands with a shorter chain than organic ligands, for example by submitting silver chalcogenide quantum dots capped with those organic ligands to a ligand-exchange on their surface, for providing the same with ligands with a shorter chain (such as, 1,2-ethanedithiol, ethanethiol, 1,3-propanedithiol, propanethiol, etc).

According to a further embodiment, the silver chalcogenide quantum dots of the light-active absorbing structure have a chalco-oxide coating passivation formed.

In the present document, the term "chalco-oxide" refers to tellurium oxide (TeOₓ⁻, 0 < x < 6). But it is not limited to this, it may also be SeOₓ⁻, or SOₓ⁻. The "minus" superscript symbol on the chalco-oxides means that they would be negatively charged species and that would make them bond to Ag atoms on the surface of the silver chalcogenide quantum dots, essentially forming silver chalco-oxides on the quantum dots surface.

According to an embodiment, the buffer structure comprises metal chalcogenide nanocrystals.

For an implementation of that embodiment, the metal chalcogenide nanocrystals of the buffer structure are solution deposited, while for another implementation they are low-temperature thermal evaporation deposited.

For some embodiments, the chalcogenide ion in the metal chalcogenide nanocrystals of the buffer structure is at least one of sulfide, selenide, telluride, or combinations thereof.

For some embodiments, the metal ion in said metal chalcogenide nanocrystals is at least one of silver, gold, bismuth, Tungsten, tin, antimony, Molybdenum, zinc, indium, copper, or combinations thereof.

For an embodiment, the metal chalcogenide nanocrystals of the buffer structure are AgBiS₂ nanocrystals.

For a preferred embodiment, the silver chalcogenide quantum dots of the light-active absorbing structure are Ag₂Te quantum dots, and the metal chalcogenide nanocrystals of the buffer structure are AgBiS₂ nanocrystals, making the photodetector device completely environmentally friendly.

According to an embodiment, the metal chalcogenide nanocrystals of the buffer structure have surface ligands with a shorter chain than organic ligands, for example by submitting metal chalcogenide nanocrystals capped with those organic ligands to a ligand-exchange on their surface, for providing the same with ligands with a shorter chain (including thiols, halides, pseudohalides or the combinations thereof).

For some embodiments of the photodetector device of the present invention, the silver chalcogenide quantum dots of the quantum dot population of the light-active absorbing structure are phosphine-free silver chalcogenide quantum dots, thus constituting a non-toxic photodetector device.

For an embodiment, the photodetector device of the present invention constitutes a photodiode.

Generally, each of the above mentioned structures, i.e. the electron transporting structure, the light-active absorbing structure, the buffer structure, and the hole transporting structure, are layer structures, each comprising one layer or a plurality of stacked layers.

An independent aspect which does not form part of the present invention, but which could be object of another invention, relates to a photodetector device, comprising:
- a substrate;
- a first electrode defined by said substrate or arranged thereon;
- an electron transporting structure arranged over said first electrode;
- a light-active absorbing structure arranged over said electron transporting structure and containing a quantum dot population comprising silver chalcogenide quantum dots, made to absorb at least one of infrared light, near infrared light, and short-wavelength infrared light; and
- a second electrode arranged over said light-active absorbing structure.

In contrast to the photodetector devices of the prior art, in the photodetector device of that independent aspect the silver chalcogenide quantum dots of the quantum dot population of the light-active absorbing structure are phosphine-free silver chalcogenide quantum dots, thus constituting a non-toxic photodetector device.

All the embodiments described in the present document for the photodetector device of the present invention are valid for describing corresponding embodiments of the photodetector device of the above described independent aspect

### BRIEF DESCRIPTION OF THE FIGURES

In the following some preferred embodiments of the invention will be described with reference to the enclosed figures. They are provided only for illustration purposes without however limiting the scope of the invention. In accordance with common practice, the components in the figures are drawn to emphasize specific features and they are not drawn to the right scale.
Figure 1 schematically shows a photodiode device structure with two electrodes, one electron transporting layer and a light-active absorbing layer, according to the above described further aspect of the present invention.
Figure 2 schematically shows the photodetector device of the present invention, for an embodiment for which the device is a photodiode device which comprises two electrodes, one electron transporting layer, a buffer layer and a light-active absorbing layer.
Figure 3 schematically shows the photodetector device of the present invention, for an embodiment for which the device is a photodiode device which comprises two electrodes, one electron transporting layer, a buffer layer, a light-active absorbing layer, and a hole transporting layer.
Figure 4 schematically shows the photodetector device of the present invention, for an embodiment for which the device is a top-illuminated photodiode device which comprises two electrodes, one electron transporting layer, a buffer layer and a light-active absorbing layer.
Figure 5 schematically shows the photodetector device of the present invention, for an embodiment for which the device is a top-illuminated photodiode device which comprises two electrodes, one electron transporting layer, a buffer layer, a light-active absorbing layer, and a hole transporting layer.
Figure 6 is a plot showing the absorption spectrum of the materials used for the buffer structure (AgBiS₂ nanocrystals) and light-active absorbing structure (Ag₂Te quantum dots), of the photodetector device of the present invention.
Figure 7 is a plot showing the representative current density-voltage (J-V) curve of a photodetector device, particularly a photodiode device, fabricated according to the structure shown in Figure 2, under dark, showing typical rectification characteristics, for an embodiment of the present invention.
Figure 8 is a plot showing the current density versus time under zero bias of the same photodetector device fabricated for obtaining Figure 7.
Figure 9 is a plot showing the spectral external quantum efficiency (EQE) of the fabricated Ag₂Te quantum dots photodiode device shown in Figure 2.
Figure 10 is a plot showing the normalized photo-response under frequency modulated 1300nm light, for the same photodiode device of Figure 9.
Figure 11 is a plot showing the frequency dependent noise power density spectrum of the same photodiode device of Figure 9, measured with different methods.
Figure 12 is a plot showing the spectral specific detectivity of the same photodiode device of Figure 9 under zero bias and a light modulation frequency of 10kHz.
Figure 13 is a plot showing the frequency dependent specific detectivity of the same photodiode device of Figure 9 under zero bias and 1380nm light.

### DESCRIPTION OF THE PREFERRED EMBODIMENTS

In the present section, photodetector devices based on silver chalcogenide quantum dots according to the present invention are disclosed. The photodetector device can be low-temperature, solution processed and functions at near infrared (NIR) -shortwave infrared (SWIR) region. Such photodetector devices fulfill the goals of high responsivity, low noise, high bandwidth and most importantly compatible with Restriction of Hazardous Substances (RoHS).

For some embodiments, photodetector devices according to the present invention are fabricated with silver bismuth sulfide nanocrystals (NCs) for the buffer structure (formed by one or more layers) and silver telluride quantum dots (QDs) for the light-active absorbing structure (formed by one or more layers). By engineering the size of Ag₂Te quantum dots, the sensitive region of the photodetector device can be tuned from 1000 nm to 2000nm. With the buffer layer of AgBiS₂ nanocrystals, the photodetector devices showed a high responsivity up to 0.25 A/W, a low noise floor of 10 fA/Hz^{0.5}, and a high specific detectivity up to 10¹² Jones. Furthermore, the performance of unencapsulated devices remained unchanged for over 30 days of storage in air. This material system introduces a new non-toxic, solution-processed, air-stable NIR-SWIR photodetectors and fills the blank of high-performance eco-friendly materials in SWIR region.

Near infrared (NIR) and shortwave infrared (SWIR) region is of significant importance in the optical communications, spectroscopy, biological imaging, surveillance and environmental mapping, etc. However, most solution-processed optoelectronic devices working in NIR/SWIR range are based on lead chalcogenides or mercury chalcogenides, which are not compatible with the Restriction of Hazardous Substances (RoHS), severely limiting their potential of commercialization.

Here, the present inventors employed environmentally friendly silver telluride (Ag₂Te) quantum dots as a light-active absorber for high performance NIR/SWIR photodetectors. Furthermore, silver bismuth sulfide (AgBiS₂) nanocrystals were introduced for the buffer structure between an electron transporting structure (made of one or more layers) and Ag₂Te quantum dot light-active absorbing structure, substantially reducing the dark current and improving the photo-detectivity.

The device architecture employs layers of different NCs/QDs to utilize their relative band alignment and reduce interface recombination. The photodetector device generally includes a structures of metal oxide serving as the electron-extracting structure, a structure of inorganic nanocrystals as the buffer structure and a structure of light-active QDs as the main light-active absorbing structure. Ag₂Te QDs have been long used as hole-transporting layer in mercury telluride (HgTe) QDs photodetectors, while the photodiode based on Ag₂Te QDs of the prior art [15] only showed < 0.5% EQE in NIR region.

The photodetector devices of the present invention showed much higher performance than previously reported devices, in terms of dark current, noise, photoresponsivity, detectivity and bandwidth.

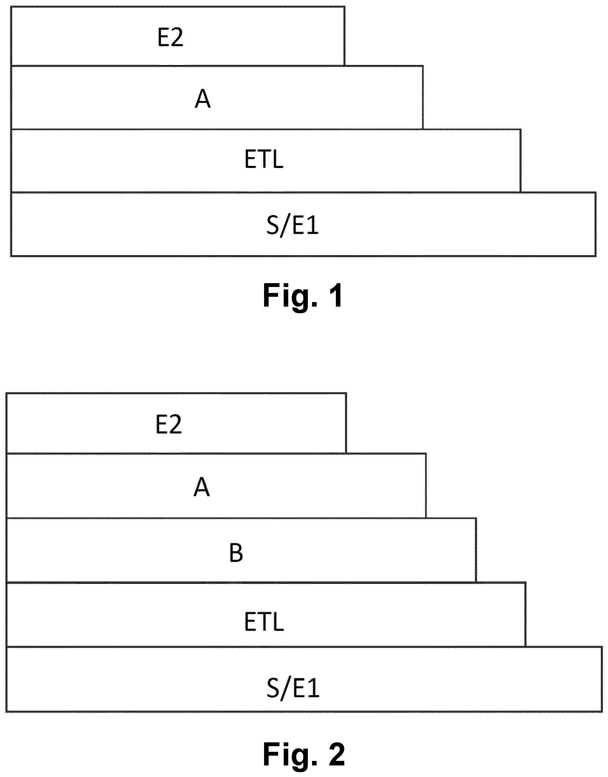

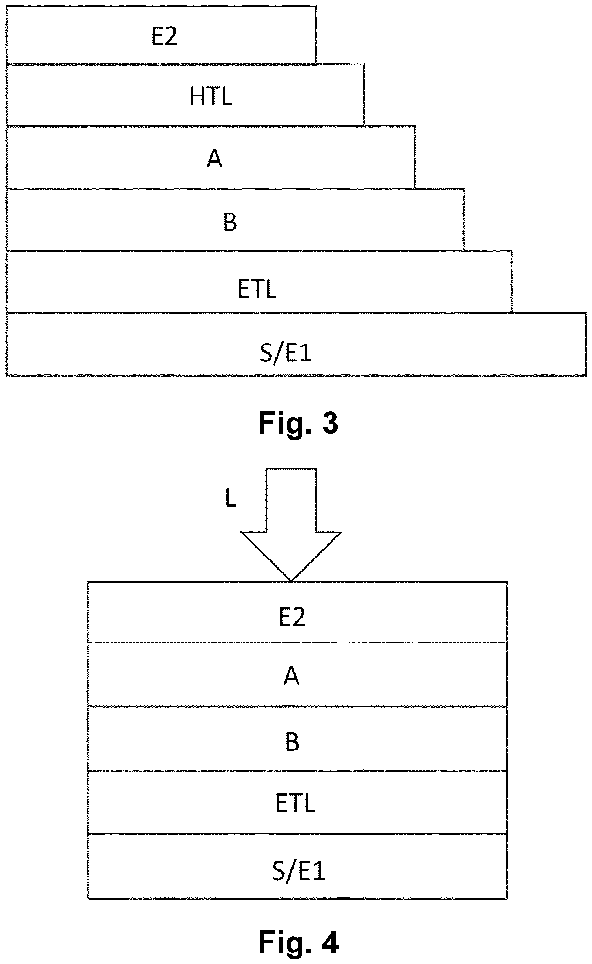

Figures 2 and 3 schematically show the structure of the photodetector device of the present invention, for different embodiments, while Figure 1 shows the structure of the photodetector device of the above described independent aspect.

As shown in Figures 2 and 3, the photodetector device of the present invention, generally implementing a photodiode, comprises:
- a substrate S;
- a first or bottom electrode E1 defined by said substrate S or arranged thereon;
- an electron transporting structure ETL arranged over said first electrode E1;
- a light-active absorbing structure A arranged over said electron transporting structure ETL and containing a quantum dot population comprising silver chalcogenide quantum dots, made to absorb at least one of infrared light, near infrared light, and short-wavelength infrared light;
- a second or top electrode E2 arranged over said light-active absorbing structure A; and
- a buffer structure B, arranged between said electron transporting structure ETL and said light-active absorbing structure A, wherein said buffer structure B is configured to reduce interface recombination.

For the embodiment of Figure 3, the photodetector device further comprises a hole transporting structure HTL, arranged between the light-active absorbing structure A and the second electrode E2.

For an embodiment, the substrate S is formed of glass and the first electrode E1 is formed of indium-doped tin oxide (ITO). It should be understood that a wide range of materials could be used for the substrate S, bottom electrode E1 and top electrode E2 without departing from the scope of this disclosure. For instance, the bottom E1 and top E2 electrodes can be made of ITO, fluorine-doped tin oxide (FTO), aluminum doped zinc oxide (AZO), Ag, Au, Pt, Pd, graphene, combinations thereof, or of other electrically conducting materials.

For an embodiment, the electron transporting structure ETL is made of tin oxide (SnO₂). Other electron transporting materials can also be used, including C60, PCBM, ZnO, TiO₂, AZO, Nb₂O₅, or the combinations thereof. The thickness of this ETL structure can vary from 1 nm up to 500 nm, depending on the embodiment.

The buffer structure B is formed, for an embodiment, by a AgBiS₂ nanocrystal film, which might comprise multiple physical layers deposited by repeating processes to obtain a suitable thickness. It should be understood that materials other than AgBiS₂ nanocrystals may be used as the buffer structure B. For example, the buffer structure B may alternatively comprise of Ag-chalcogenide quantum dots of smaller size (equivalent to larger bandgap) than the quantum dots of the light-active absorbing structure A, or any other quantum dot structure whose Fermi level is lower than that of the light-active absorbing structure A, i.e. the material is considered to be less p-type doped than that of the light-active absorbing structure A, and higher than the Fermi level of the ETL structure.

For some embodiments, this buffer structure B also comprises organic semiconductors such as PCBM or C60 deposited either via solution processing or low-temperature thermal evaporation.

In another embodiment, the buffer structure B is made of transition metal dichalcogenide layered semiconductors such as MoS₂, WS₂, WSe₂ etc. The overall thickness of this buffer structure B is preferably in the range from 2 nm up to 200 nm, or thicker.

Furthermore, the photodetector device includes a film of Ag₂Te QDs as the light-active absorbing structure. The Ag₂Te QD film might consist of multiple physical layers deposited by repeating processes to obtain a desired thickness. The Ag₂Te QD film might also consist of multiple layers of Ag₂Te QDs treated with different ligands. It should be understood that the materials in the light-active absorbing structure may include other silver chalcogenide (Ag₂S, Ag₂Se, Ag₂Te, or their alloys).

The hole transporting structure HTL (made of one or more layers), included for the embodiment of Figure 3, may be made of PTAA, PTB7, PTB7-th, P3HT, Spiro-OMeTAD, PM6. Besides organic semiconductors, this structure may also comprise quantum dots of Ag-chalcogenide of smaller size (that is with higher bandgap) and are more heavily p-type doped than the one so the light-active absorbing structure, such that the Fermi level of this structure is higher than the Fermi level of the light-active absorbing structure.

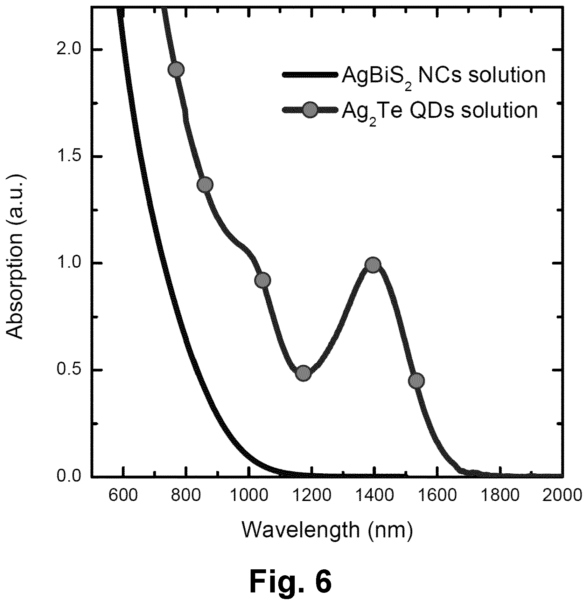

In an example, oleic acid capped AgBiS₂ nanocrystals are used for the buffer structure B and oleylamine/dodecanethiol co-capped Ag₂Te quantum dots with first exciton peak at ~1400nm are used to fabricate an IR absorbing film implementing the light-active absorbing structure A. 3-mercaptopropionic acid (MPA) or 1,2-ethanedithiol (EDT) is used to ligand-exchange oleic acid on the surface of AgBiS₂ nanocrystals and 1,2-ethanedithiol (EDT) is used to ligand-exchange oleylamine/dodecanethiol on the surface of Ag₂Te quantum dots. Figure 6 shows the absorption spectrum of the resultant AgBiS₂ nanocrystal film and Ag₂Te quantum dot films.

For an embodiment, the light-active absorbing structure A comprising Ag-chalcogenide is further undergone a process to create the formation of chalco-oxides on the surface of the quantum dots. This has been found important to make a stable device and acts to further passivate electronic trap states on the quantum dots. For example in the case of Ag₂Te QD absorber layer a mild annealing step at 100°C is performed that yields to the formation of TeO₂⁻, that is formed on the surface of the Ag₂Te quantum dots.

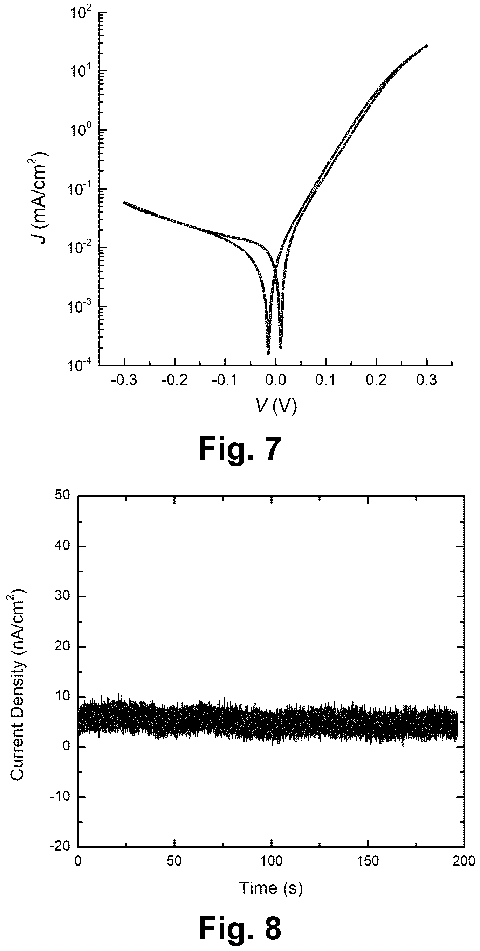

In an example, photodetector devices, particularly photodiode devices, are fabricated as Glass/ITO/SnO₂/AgBiS₂/Ag₂Te/Au, according to the structure shown in Figure 2, i.e. for respectively the substrate S, the fist electrode E1, the electrode transport structure ETL, the buffer structure B, the light-active absorbing structure A, and the second electrode E2. The thickness of SnO₂, AgBiS₂ and Ag₂Te are 20nm, 20nm and ~100nm, respectively. Figure 7 shows the representative current-density-voltage (*J-V*) curve under dark, showing typical rectification characteristics. The dark current density under zero bias is as low as 5 nA/cm², as shown in Figure 8.

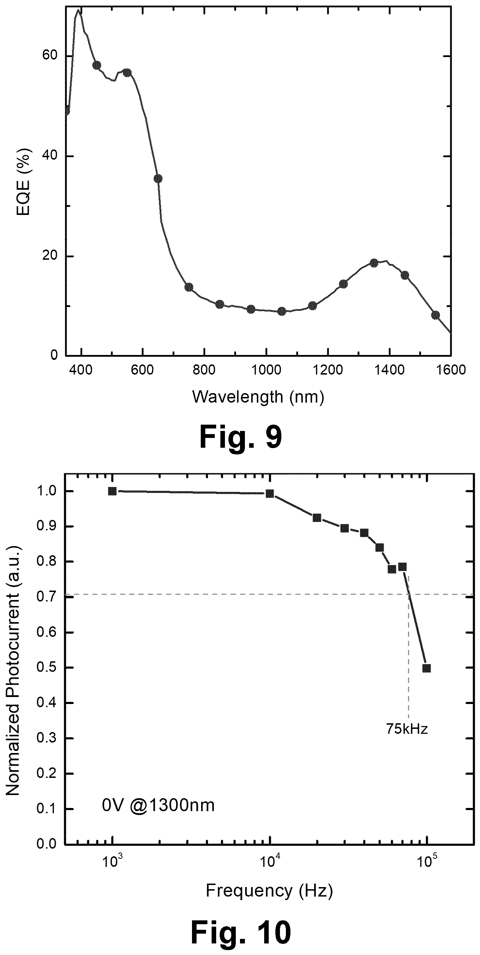

Figure 9 further shows the representative spectral response (external quantum efficiency, EQE) of typical Ag₂Te photodiodes with Ag₂Te QDs' absorption peak locating at ~1400nm (Figure 6) and device architecture indicating in Figure 2. The device exhibits an EQE up to 20% and photo-responsivity of 0.22 A/W. The broadband spectral response at zero bias ensures that the device works over a wide spectral range from 350nm to 1600nm, consistent with the absorption spectrum of the Ag₂Te QDs.

The frequency response shown in Figure 10 further indicates the fast response of the manufactured photodiode device with a -3dB bandwidth of up to 75 kHz in self-powered mode, for the same structure and parameters of Figure 9.

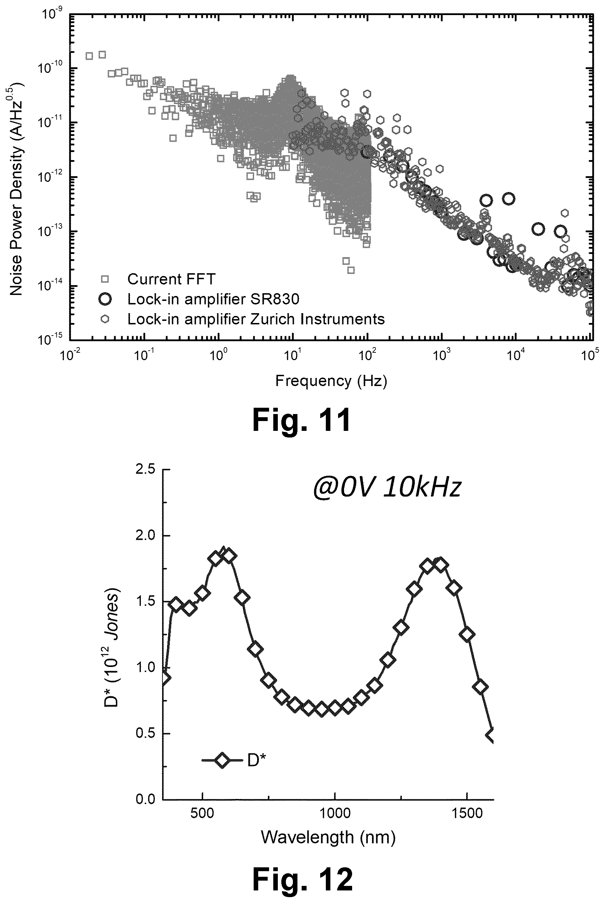

Figure 11 shows that the frequency-dependent current noise spectrum of the Ag₂Te QD photodiode measured by different lock-in amplifiers and current fast-Fourier-transform (FFT) method at zero bias, for the same structure and parameters of Figure 9. The noise reaches a noise floor of 10⁻¹⁴ A/Hz^{0.5} at high frequencies.

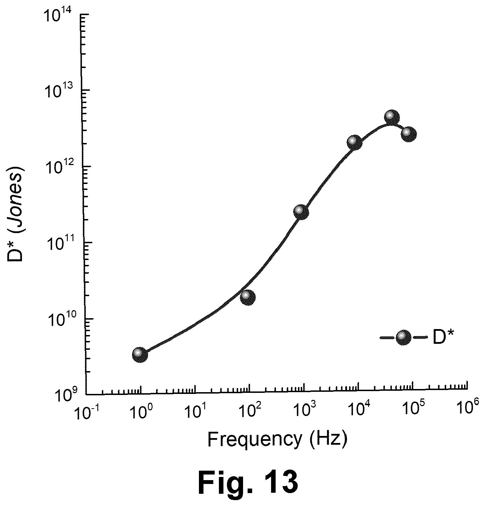

The measured room-temperature specific detectivity (D*) is displayed in Figure 12, for the same structure and parameters of Figure 9. The optimal D* value of the Ag₂Te QD photodiode is up to 1.7×10¹² Jones at 10kHz under zero bias with a wavelength of 1380nm (Figure 13).

### Top illuminated photodiodes:

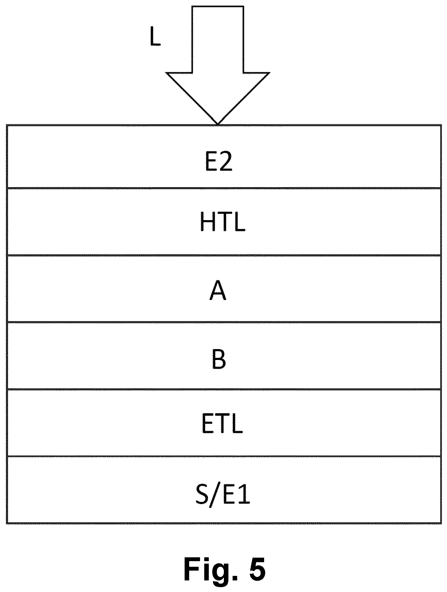

Figures 4 and 5 show the device architectures of read-out integrated circuit (ROIC) compatible top-illuminated photodiodes, according to the present invention. The photodiode includes a substrate A and a conductive first electrode E1. The substrate S is formed of ROIC and the conductive bottom electrode E1 is formed, for example, of Au. The photodiode also includes a top electrode E2. It should be understood that a wide range of materials could be used for the substrate S, bottom electrode E1 and top electrode E2 without departing from the scope of this disclosure. For instance, the bottom E1 and top E2 electrodes can be made of ITO, fluorine-doped tin oxide (FTO), aluminum doped zinc oxide (AZO), Ag, Au, Graphene, or other conducting materials.

The top-illuminated photodiode also includes an electron transporting structure ETL. In this example, the electron transporting structure ETL is made of tin oxide (SnO₂). Other electron transporting materials can also be used, including C60, PCBM, ZnO, TiO₂, AZO, Nb₂O₅, or the combinations thereof.

The photodiode device further includes a buffer structure B. In this example, the buffer structure B is a AgBiS₂ nanocrystal film, which might comprise multiple physical layers deposited by repeating processes to obtain a suitable thickness. It should be understood that materials other than AgBiS₂ nanocrystals may be used as the buffer structure B.

Furthermore, the top-illuminated photodiode includes a film of Ag₂Te QDs as the light-active absorbing structure A. The Ag₂Te QD film might consist of multiple physical layers deposited by repeating processes to obtain a desired thickness. The Ag₂Te QD film might also consist of multiple layers of Ag₂Te QDs treated with different ligands. It should be understood that the materials in the light-active absorbing layer may include, alternatively or complementarily, other silver chalcogenides (Ag₂S, Ag₂Se, Ag₂Te, or their alloys).

For the embodiment of Figure 5, the photodiode also includes a hole transporting structure HTL, which may be PTAA, PTB7, PTB7-th, P3HT, Spiro-OMeTAD, PM6.

### Abbreviations:

PTAA: Poly[bis(4-phenyl)(2,4,6-trimethylphenyl)amine
PTB7: Poly [[4,8-bis[(2-ethylhexyl)oxy]benzo[1,2-b:4,5-b']dithiophene-2,6-diyl][3-fluoro-2-[(2-ethylhexyl)carbonyl]thieno[3,4-b]thiophenediyl ]]
PTB7-th: Poly[4,8-bis(5-(2-ethylhexyl)thiophen-2-yl)benzo[1,2-b;4,5-b']dithiophene-2,6-diyl-alt-(4-(2-ethylhexyl)-3-fluorothieno[3,4-b]thiophene-)-2-carboxylate-2-6-diyl)] P3HT: Poly(3-hexylthiophene-2,5-diyl)
Spiro-OMeTAD: 2,2',7,7'-Tetrakis[N,N-di(4-methoxyphenyl)amino]-9,9'-spirobifluorene
PM6: Poly[(2,6-(4,8-bis(5-(2-ethylhexyl-3-fluoro)thiophen-2-yl)-benzo[1,2-b:4,5-b']dithiophene))-alt-(5,5-(1',3'-di-2-thienyl-5',7'-bis(2-ethylhexyl)benzo[1',2'-c:4',5'-c']dithiophene-4,8-dione)]
PCBM: Fullerene derivative [6,6]-phenyl-C61-butyric acid methyl ester

## Claims

1. A photodetector device, comprising:
- a substrate (S);
- a first electrode (E1) defined by said substrate (S) or arranged thereon;
- an electron transporting structure (ETL) arranged over said first electrode (E1);
- a light-active absorbing structure (A) arranged over said electron transporting structure (ETL) and containing a quantum dot population comprising silver chalcogenide quantum dots, made to absorb at least one of infrared light, near infrared light, and short-wavelength infrared light; and
- a second electrode (E2) arranged over said light-active absorbing structure (A);
**characterized in that** the photodetector device further comprises a buffer structure (B), arranged between said electron transporting structure (ETL) and said light-active absorbing structure (A), wherein said buffer structure (B) is configured to reduce interface recombination.

2. The photodetector device of claim 1, further comprising a hole transporting structure (HTL), arranged between said light-active absorbing structure (A) and said second electrode (E2).

3. The photodetector device of any of the previous claims, wherein the photodetector device is a top-illuminated photodetector, said second electrode (E2) is configured, sized and arranged to allow at least one of impinging infrared light, impinging near infrared light, and impinging short-wavelength infrared light to transmit therethrough and be absorbed by the light-active absorbing structure (A).

4. The photodetector device of any of the previous claims, wherein a readout integrated circuit, ROIC, is built on the substrate (S).

5. The photodetector device of any of the previous claims, wherein the chalcogenide ion in the silver chalcogenide quantum dots of the light-active absorbing structure (A) is at least one of sulfide, selenide, telluride, or combinations thereof.

6. The photodetector device of claim 5, wherein said silver chalcogenide quantum dots of the light-active absorbing structure (A) are Ag₂Te quantum dots.

7. The photodetector device of any of the previous claims, wherein the silver chalcogenide quantum dots of the light-active absorbing structure (A) are solution deposited.

8. The photodetector device of any of the previous claims, wherein the silver chalcogenide quantum dots of the light-active absorbing structure (A) have surface ligands with a shorter chain than organic ligands.

9. The photodetector device of any of the previous claims, wherein the silver chalcogenide quantum dots of the light-active absorbing structure (A) have a chalco-oxide coating passivation formed.

10. The photodetector device of any of the previous claims, wherein said buffer structure (B) comprises metal chalcogenide nanocrystals.

11. The photodetector device of claim 10, wherein said metal chalcogenide nanocrystals of the buffer structure (B) are solution deposited.

12. The photodetector device of claim 10 or 11, wherein the chalcogenide ion in said metal chalcogenide nanocrystals is at least one of sulfide, selenide, telluride, or combinations thereof, and the metal ion in said metal chalcogenide nanocrystals is at least one of silver, gold, bismuth, Tungsten, tin, antimony, Molybdenum, zinc, indium, copper, or combinations thereof.

13. The photodetector device of claim 12, wherein said metal chalcogenide nanocrystals of the buffer structure (B) are AgBiS₂ nanocrystals.

14. The photodetector device of any of the previous claims, wherein the metal chalcogenide nanocrystals of the buffer structure (B) have surface ligands with a shorter chain than organic ligands.

15. The photodetector device of any of the previous claims, constituting a photodiode.
